# EUROPEAN PATENT APPLICATION

(11) **EP 0 858 253 A1**
(43) Date of publication of application: **12.08.1998**
(21) Application number: 97830039.0
(22) Date of filing: 05.02.1997
(51) Int. Cl.: H05K 7/00, H02B 1/30

(54) **Modular case structure for housing electrical equipment**

(71) Applicant: BTICINO S.P.A., 20154 Milano (IT)
(72) Inventor: Fabrizi,Fabrizio, I-24100 Bergamo (IT)
(74) Representative: Ferroni, Filippo

(57) **Abstract**

The invention relates to a structure for modular type cases intended for housing electrical equipment in general.

This structure incorporates a frame (1) consisting of three flat parts (2, 3, 4) suitable for defining corresponding walls of the case; between each of these parts and the part adjacent thereto there are one or more predetermined folding lines (6, 7) that facilitate the folding of the frame (1) and the consequent forming of the walls of the case.

The structure of the invention is easy to pack, transport and store because for these operations the aforesaid frame (1) is in a flat configuration making it very easy to stack and handle. This has great benefits for the entire cycle of production and marketing.

Such a structure also considerably simplifies the assembly of the cases as it reduces down the number of components to be assembled.

## Description

The invention relates to a structure for a modular case intended for housing electrical equipment, said structure comprising a frame with at least three basically flat parts joined together and suitable for defining respective walls of the case.

As is known in civil or industrial electrical systems, control apparatuses, though not only them, such as switches, analogical indicators, indicator lamps and so forth, are usually incorporated in panels installed inside modular cases of a variety of shapes and dimensions.

These cases generally consist of assembled sheet metal parts, although the use of plastics or other materials is not uncommon; for example, partially or totally transparent panels or doors are often used to allow direct visibility from the exterior of the electrical equipment housed inside the cases considered here.

In addition, because of their numerous applications case, structures are often modular and are marketed in the form of a self-assembly kit: this allows users to customize their cases according to their particular needs and at the same time allows manufacturers to reduce costs, by virtue of the optimization of the production cycle which can be achieved with a suitable design.

Hence, for a particular model of case, series of standardized components are usually provided (i.e. uprights, cross members, shelves, partitions, walls etc.) that fit together with increasing dimensions: the customer can thus first select components from the catalogue to build up a structure corresponding to his needs.

In this context it should be clarified, before going further, that in this description and the following claims, the term "case" is intended to indicate generically any form of such a furniture; consequently this term covers the larger sort, namely free-standing cases and the smaller sort, i.e. wall-mounted cases, as well as those known in the trade as "panels" and any other type of furniture similar to cases even if not referred to by that name.

Furthermore, as another way of diversifying the models of cases, it is not infrequent for several variants of an individual component to also be available; the transparent panels or doors mentioned earlier are an example on this point: they are frequently catalogued by the manufactured possible alternatives to panels or doors made wholly of sheet metal.

At the present time, in order to avoid an excessive proliferation of components requiring assembly, which would make the mounting by users of case structures too laborious, the structures are produced and marketed in preassembled forms: in practice, that is to say, the cases, which in general are essentially parallelepipeds, are made available to the public in the form of structures consisting of three or more walls (i.e. the faces of the parallelepiped) already fitted into a single frame, leaving to the end user the task of simply fitting the closing panels or doors and installing any internal accessories such as shelves, slides and the like. While this solution reduces the number of components that have to be assembled, thus providing all the benefits discussed above, it suffers from the drawback that the amount of space occupied by preassembled forms is considerable, especially in relation to their weight, which is usually not very relevant: transport, and more generally packaging, handling and storage of these structures is therefore costly in relation to their weight and volume, to an extent that they may excessively affect the price at which they are sold.

The object which the present invention seeks to achieve is therefore to provide a structure for a modular case intended for housing electrical equipment, having features such as to overcome the disadvantages referred to within the prior art.

This object is achieved by a structure of the type set forth at the beginning of this description, the characterizing features thereof are disclosed in the claims which will follow.

In order to explain the invention with its features and the advantages provided by the latter, there now follows a description thereof on the basis of a non-exclusive preferred embodiment which is illustrated in the accompanying drawings, wherein:
- Figure 1 shows an isometric view of a frame of a structure according to the invention, in a first operative condition:
- Figure 2 shows an isometric view of the frame shown in Figure 1, in a second operative condition;
- Figure 3 shows a variant of the frame of the previous figures.

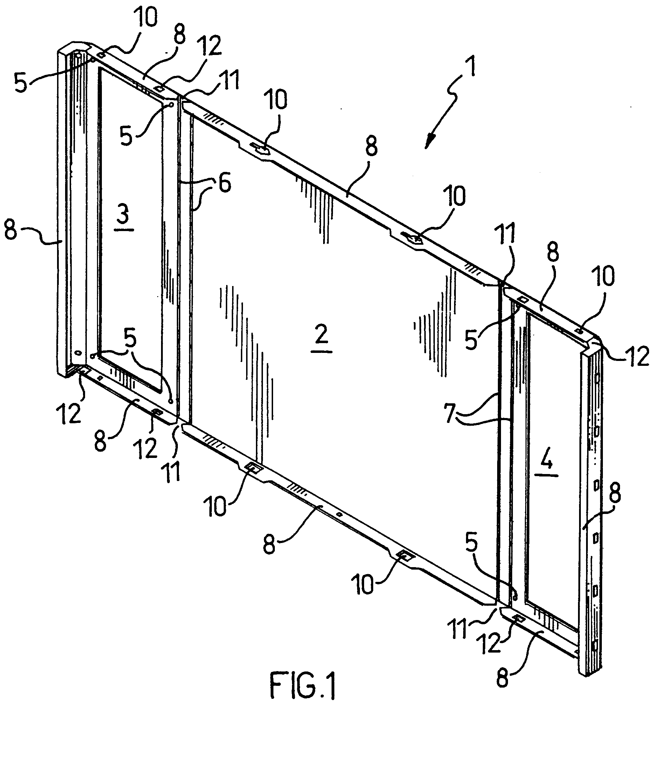

With reference to these figures, the numeral 1 denotes the whole of the structural frame according to the present invention which, in the first configuration, illustrated in Figure 1, is essentially flat and is subdivided into three parts: a central part 2, with lateral parts 3 and 4 on opposite sides thereof.

This frame consists of a single component manufactured from sheet metal.

More precisely, the central part 2, which corresponds to the rear wall of the enclosure structure in accordance with the invention, consists entirely of the metal sheet; but the lateral parts 3 and 4 are configured as open rectangular frames, with a series of holes 5 at the vertices to allow the installation of closure panels not shown in the drawings.

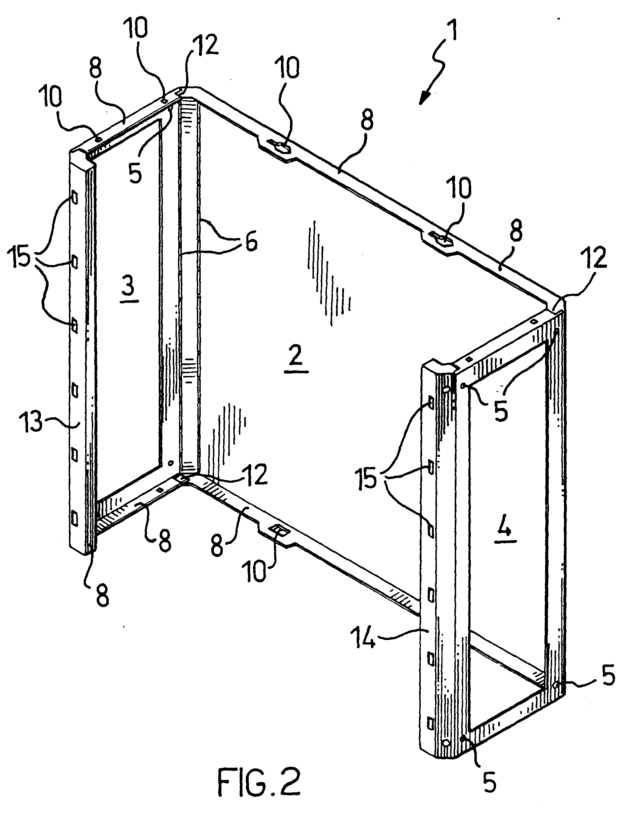

Between the central part 2 of the frame and the lateral parts 3 and 4, two rows of elongated slots 6 and 7, respectively, are formed to define predetermined holding lines along which the frame is bent into its second configuration shown in Figure 2.

In particular, in this embodiment of the invention, the elongated slots 6 and 7 give the structure in question blunt edges when the frame 1 is bent into the second operative condition referred to above; it should also be observed that with these blunt edges, the metal sheet of the frame is not bent with angles of less than or equal to 90° (bending the metal sheet through angles that are too small could over-stress the material and weaken its mechanical properties).

In addition, in the first operative condition the metal sheet of which the frame 1 is made is also folded bent around the edges to form a raised lip 8 having a series of holes and openings 10 with a variety of different shapes and dimensions, as well as a number of notches 11 and slots 12: this lip with its holes and openings can be used, if required, for attaching walls to the top and bottom of the central part 2 when the frame is bent into the second configuration, thereby completing the structure of the invention in much the same way as was mentioned earlier with regard to the lateral parts 3 and 4.

It should also be pointed out that the ends 13 and 14 of parts 3 and 4 of the frame 1 are bent in such a way that in the final configuration (see Figure 2) of the frame they are parallel with the rear wall 2 of the case structure: this is so that a panel or door, not shown in the drawings, can be attached to them, making use of suitable holes 15 provided for this purpose; as is obvious, a panel can be attached by means of screws passing through the holes 15 in the abovementioned ends 13 and 14, as could also the hinges of a door.

As far as the functional aspects of the structure of the invention are concerned, the following text may also be referred to.

For the operations of packaging, transport and storage of the structure, the frame 1 is presented in the first operative condition, i.e. basically flat.

For its installation, however, the lateral parts 3 and 4 are folded along the rows of slots 6 and 7 to achieve the configuration shown in Figure 2; it should be noticed that following this folding, the notches 11 on the lip of the frame allow certain ends of this lip to overlap so as to engage the slots 12 with slight force fitting in order to keep the different parts of the frame more firmly together. It just matters to point out that the frame is bent manually very easily by a user owing to the presence of the rows of slots 6 and 7 which locally weaken the metal sheet and facilitate its deformation.

When the frame is in the final condition, it is then possible to attach the lateral closure panels against parts 3 and 4, the front door for closing the case structure, any further panels above and below the central part, and lastly the accessories with the electrical equipment which the user selects as required.

From the foregoing it may therefore be appreciated how the structure according to the invention achieves the object thereof set out above.

Thus, the number of components to be assembled is small since as the frame 1 forming the main component thereof can be produced as a single part; and the definitive assembly of the structure therefore involves simply folding the frame manually and attaching a few other components as has just been mentioned: all these operations are however very simple and do not require the use of special instruments or tools that would be difficult to handle.

At the same time it is important to emphasize that this result is achieved while simultaneously limiting the bulk of the structure so that it can be packaged, stored and transported: the first condition of the frame 1 is ideally suitable to this aim because its flat shape allows many frames to be stacked in a small space, and even the manipulation and handling of these is greatly facilitated by this flattened form.

It is just necessary to point out that all these results cannot of course be achieved with the preassembled structures of the prior art.

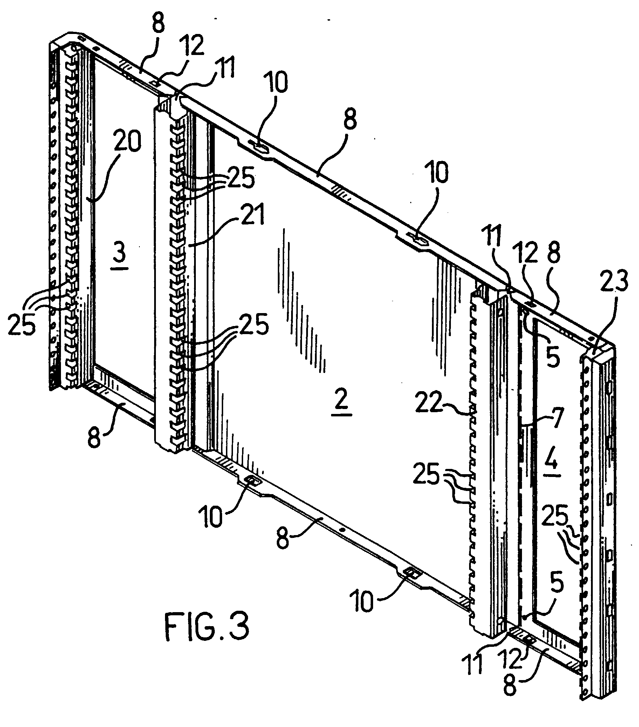

Alternative forms of the invention to that described hitherto are not of course excluded; one of these is shown in the drawings in Figure 3, where the same numerals indicate parts of the invention that are structurally or functionally equivalent to those discussed earlier.

This alternative form differs basically in the presence of certain channel sections 20, 21, 22 and 23 positioned in the blunt edges of the parallelepiped formed by the structure when the frame thereof is folded into its final configuration; these sections include a series of seats 25 on which shelves (not shown in the drawings) can be mounted.

When the frame is folded in the same way as explained above, the seats 25 will be found to be in the vertices of a quadrilateral and can therefore support a shelf of corresponding shape whose corners are inserted into these seats.

Another form of the structure which it is possible to envisage as an alternative to the previous forms could be produced by making a frame of the type considered above, in which, however, its lateral parts 3 and 4 are not configured as open frames but are similar to the central part 2, i.e. consist of solid sheet metal.

This would make it possible to further reduce the number of components a user would have to assemble in order to erect the structure in accordance with the invention, by making it unnecessary to fit closure panels to the sides afterwards.

In addition, although the embodiment of the structure of the previous examples wherein the central part 2 consists of a metal sheet is generally to be preferred, since it is simple to manufacture and gives the frame adequate stiffness, it is also possible for this central part 2 to be made in the form of an open frame or the like, possibly with braces or ties for stiffening.

Nor should the possibility of providing walls joined to the top and bottom of the central part 2 by rows of slots, in the same way as indicated earlier for the lateral parts 3 and 4, be ruled out; on this point, however, it should be noted that the structure illustrated in the drawings, which does not have walls attached to the top and bottom of the central part 2, is to be preferred in those cases in which it is desired to remove the heat produced by the electrical equipment mounted inside the case, by means of ventilation; clearly, this version is not advisable when the case is to be used in environments exposed to atmospheric agents.

Lastly it should be remarked that the possibility of making the predetermined folding lines - consisting in the previous example of rows of slots - in some different way, is not to be ruled out; in other words the possibility of replacing these rows of slots with score lines, incisions, ribs or other machining of the frame material that can assist its folding in accordance with the teaching deriving from the above description, should not be ruled out.

It is also just to point out that the number of predetermined folding lines may likewise be different from the two rows of slots 6 and 7 since their purpose is, as explained earlier, to produce rounded corners in the folded frame so that the metal sheet or other material of which it is made is not deformed too severely.

It will however be appreciated that although the presence of blunt angles is to be preferred in certain cases for the reasons outlined above, the possibility should however not be ruled out of having modular case structures with sharp edges, that is to say folded at the corners along only one predetermined folding line represented by one row of slots, or by one of the alternatives to the slots mentioned immediately above; the various solutions chosen will depend, on a case by case basis, on the material of the frame, on its thickness, on the type of folding line adopted (i.e. slots, score lines etc.).

It just matters to add furthermore that there may be more than two folding lines; an example would be case structures in which there are junctions between the walls having blunt profiles of polygonal shape: in these variants there may be three or more predetermined folding lines laid side-by-side on one frame part and on the adjacent frame part, along which the frame can be folded so as to obtain the abovementioned profile.

All the variants of the invention discussed herein and any other alternatives thereof which may be devised by persons skilled in the art, however, fall within the scope of protection defined by the following claims.

## Claims

1. Structure for a modular case intended for housing electrical equipment, said structure including a frame (1) having at least three basically flat parts (2, 3, 4) joined together and suitable for defining respec-tive walls of the case, characterized in that the frame (1) comprises at least one predetermined folding line (6, 7) between at least one of said parts (2, 3, 4) and a part adjacent thereto, along which the frame is folded to form the case walls corresponding to these parts.

2. Structure for a case according to Claim 1, in which said at least one folding line consists of a multiplicity of aligned slots (6, 7) passing through the material of the frame (1).

3. Structure for a case according to either of Claims 1 and 2, in which the frame is made of sheet metal, at least along the predetermined folding lines (6, 7).

4. Structure for a case according to any one of the previous claims, in which the frame (1) comprises a central part (2) suitable for defining the rear wall of the case, and two lateral parts (3, 4) arranged on either side of the central part (2), suitable for defining respective lateral walls of the case.

5. Structure for a case according to any one of the previous claims, in which at least one of said parts (2, 3, 4) is configured essentially as an open frame.

6. Structure for a case according to any one of the previous claims, characterized in that the frame (1) is surrounded by a lip (8) at approximately right angles to the plane of the aforesaid parts (2, 3, 4).

7. Structure for a case according to any one of the previous claims, characterized in that it comprises respective sections (20, 21, 22, 23) in the edges of the case defined by the folding of the frame (1), with a plurality of seats (25) formed in these sections for supporting shelves.

8. Modular case for housing electrical equipment, comprising a structure in accordance with any of the previous claims.
